# EUROPÄISCHE PATENTANMELDUNG

(11) **EP 2 851 815 A1**
(43) Veröffentlichungstag der Anmeldung: **25.03.2015**
(21) Anmeldenummer: 13184920.0
(22) Anmeldetag: 18.09.2013
(51) Int. Cl.: G06F 17/50, G05B 17/02

(54) **Testeinrichtung zum Echtzeittest eines virtuellen Steuergeräts**

(71) Anmelder: dSPACE digital signal processing and control engineering GmbH, 33102 Paderborn (DE)
(72) Erfinder: Leinfellner, Robert, 33098 Paderborn (DE); Kerstan, Timo, 33154 Salzkotten (DE)

(57) **Zusammenfassung**

Dargestellt und beschrieben ist eine Testeinrichtung (1) zum Echtzeittest zumindest eines Teils eines virtuellen Steuergeräts (3) mit einem Steuergerätecode (EC), wobei die Testeinrichtung (1) wenigstens einen Rechenkern (4) ersten Typs mit einem ersten Instruktionssatz (IS1) und wenigstens eine Simulationsumgebung (5) zur Echtzeitsimulation der Umgebung des virtuellen Steuergeräts (3) aufweist, und wobei die Simulationsumgebung (5) und der Steuergerätecode (EC) mit wenigstens einem Rechenkern (4) ersten Typs berechnet wird.

Der Test eines virtuellen Steuergeräts (3) mit Steuergerätecode (EC), der auf einem Rechenkern (6) zweiten Typs mit einem zweiten Instruktionssatz (IS2) lauffähig ist, wobei der zweite Instruktionssatz (IS2) des Rechenkerns (6) zweiten Typs von dem ersten Instruktionssatz (IS1) des Rechenkerns (4) ersten Typs verschieden ist wird dadurch ermöglicht, dass ein Rechenkern (4) ersten Typs einen Emulator (7) zur Emulation des Rechenkerns (6) zweiten Typs ausführt und der Emulator (7) den Steuergerätecode (EC) ausführt und dass der Emulator (7) eine Simulationsumgebungsschnittstelle (8) zum Austausch von Daten und/oder Ereignissen mit der Simulationsumgebung (5) aufweist.

## Beschreibung

Die Erfindung betrifft eine Testeinrichtung zum Echtzeittest zumindest eines Teils eines virtuellen Steuergeräts mit einem Steuergerätecode, wobei die Testeinrichtung wenigstens einen Rechenkern ersten Typs mit einem ersten Instruktionssatz und wenigstens eine Simulationsumgebung zur Echtzeitsimulation der Umgebung des virtuellen Steuergeräts aufweist, und wobei die Simulationsumgebung und der Steuergerätecode mit wenigstens einem Rechenkern ersten Typs berechnet wird.

Die vorgenannten Testeinrichtungen sind im Stand der Technik aus dem Bereich der Steuergeräteentwicklung bekannt, sie werden in der Forschung und Entwicklung verwendet, wobei häufige Anwendungsgebiete im automotiven Bereich und in der Luftund Raumfahrttechnik liegen.

Den Testeinrichtungen zum Echtzeittest eines virtuellen Steuergeräts liegen konzeptionell solche Testeinrichtungen zugrunde, die zum Test eines realen Steuergeräts dienen. Solche Testeinrichtungen dienen zur Durchführung sogenannter Hardware-in-the-Loop-Tests (HIL-Test) von realen Steuergeräten oder eines Verbunds von realen Steuergeräten, die in ihrem Zusammenspiel zu überprüfen sind. Bei realen Steuergeräten handelt es sich vorliegend um echtzeitfähige Kleinrechner, die zur Beeinflussung eines technischen Prozesses eingesetzt werden. Reale Steuergeräte verfügen demnach über einen Rechenkern, auf dem ein echtzeitfähiges Betriebssystem ausgeführt wird, mit dessen Hilfe regelnde und/oder steuernde Abtastsysteme - wie sie seit Jahrzehnten aus der Systemtheorie bekannt sind - implementiert sind. Reale Steuergeräte wirken auf den zu beeinflussenden Prozess über eine I/O-Schnittstelle (Input/Output) ein bzw. beziehen über die I/O-Schnittstelle messtechnisch Informationen über den Prozess. Bei dem Test eines realen Steuergeräts mit Hilfe eines HIL-Simulators handelt es sich um den letzten Schritt des Tests eines realen Steuergeräts, bevor es in seiner tatsächlichen Einsatzumgebung zur Anwendung gelangt. Bei dem realen Steuergerät kann es sich beispielsweise um ein Motorsteuergerät eines Verbrennungsmotors handeln.

Zum Echtzeittest des realen Steuergeräts wird das reale Steuergerät über seine I/O-Schnittstellen mit der Testeinrichtung verbunden. Auf der mit einem Rechenkern oder mit mehreren Rechenkernen ersten Typs ausgestatteten Testeinrichtung wird eine Simulationsumgebung betrieben, die die Umgebung des realen Steuergeräts ebenfalls in Echtzeit simulieren kann. Im Falle des vorgenannten Beispiels eines Motorsteuergeräts handelt es sich dann beispielsweise um die Echtzeitsimulation des Verbrennungsmotors. Aus dem Vorstehenden ergibt sich, dass die Echtzeitfähigkeit der Testeinrichtung für den Test essentiell ist, denn letztlich soll anhand des Tests auch herausgefunden werden, ob sich das Steuergerät unter Echtzeitbedingungen bewährt, ob also z. B. implementierte Algorithmen in den geforderten Abtastintervallen berechnet werden können usw.

Die HIL-Simulation von realen Steuergeräten hat erkennbar den Vorteil, dass das Verhalten der realen Steuergeräte gefahrlos in einer simulierten Umgebung getestet werden kann. Ebenso offenkundig ist jedoch der Nachteil, dass das reale Steuergerät als solches überhaupt vorhanden sein muss, um den Test durchführen zu können. Dies ist deshalb nachteilig, weil die Entwicklung eines Steuergerätes, das in einer Serienanwendung zum Einsatz kommen soll, mit erheblichem Aufwand und Kosten verbunden ist. Wenn sich erst beim Test des realen Steuergeräts herausstellt, dass es bestimmte Anforderungen nicht erfüllt, sind nicht selten erhebliche Anstrengungen erforderlich, die über eine einfache "Nachbesserung" weit hinausgehen, im ungünstigsten Fall muss das Konzept des Steuergeräts vollständig neu überdacht werden, so dass praktisch eine Neuentwicklung des realen Steuergeräts erforderlich ist; die Folge ist, dass zeitliche und kostenmäßige Planungsziele nicht eingehalten werden können.

Um dieser Problematik zu begegnen, um also möglichst frühzeitig bekannte Komponenten des zu überprüfenden Steuergeräts in einen Funktionstest mit einbeziehen zu können, ist das Konzept des sogenannten virtuellen Steuergeräts erdacht worden ("Virtual Validation with dSPACE: Early PC-Based Validation of ECU Software", Produktinformation dSPACE, 2013). Hier muss das Steuergerät zwar nicht physikalisch vorliegen, jedoch muss der Steuergerätecode in einer hardwareunabhängigen Hochsprache (z. B. C/C++, Assembler) vorliegen. In diesem Fall wird der Steuergerätecode in den ersten Instruktionssatz des Rechenkerns ersten Typs übersetzt, so dass der Steuergerätecode auf der Testeinrichtung mit dem Rechenkern ersten Typs ausgeführt werden kann. Im Regelfall unterscheiden sich die Prozessor-/Rechenkernimplementierung der Testeinrichtungen und des zu testenden Steuergeräts. In einer Testeinrichtung auf PC-Basis kommen beispielsweise Intel-Prozessoren als Rechenkerne ersten Typs zum Einsatz, die einen entsprechenden Instruktionssatz (z. B. Intel IA32) aufweisen, wohingegen Steuergeräte meist Mikrocontroller-basiert sind, also einen vom Rechenkern ersten Typs abweichenden Rechenkern zweiten Typs aufweisen, der einen von dem ersten Instruktionssatz abweichenden zweiten Instruktionssatz aufweist (z. B. C166 Instruktionssatz der C166-Mikrocontroller-Familie).

Die zuvor skizzierte Vorgehensweise bringt den Nachteil mit sich, dass nicht der originäre Steuergerätecode, der eigentlich für einen Rechenkern zweiten Typs lauffähig ist, von der Testeinrichtung getestet wird, sondern nur die Übertragung des Steuergerätecodes auf den ersten Instruktionssatz des Rechenkern ersten Typs der Testeinrichtung. Eine weitere Schwierigkeit liegt darin, dass der Steuergerätecode zur Realisierung der skizzierten Vorgehensweise überhaupt in einer Hochsprache vorliegen muss, damit er auf einen bestimmten Instruktionssatz übertragen werden kann. Diese Voraussetzung ist in vielen Anwendungsfällen jedoch nicht erfüllt oder nicht erfüllbar, beispielsweise aus Gründen der Geheimhaltung von Implementierungsdetails.

Aufgabe der vorliegenden Erfindung ist es daher, eine Testeinrichtung zum Echtzeittest eines virtuellen Steuergeräts mit einem Steuergerätecode anzugeben, mit der die zuvor aufgezeigten Nachteile der Echtzeit-Testeinrichtungen, von denen die Erfindung ausgeht, vermieden werden.

Die zuvor hergeleitete und aufgezeigte Aufgabe wird bei der eingangs dargestellten Testeinrichtung dadurch gelöst, dass der Steuergerätecode auf einem Rechenkern zweiten Typs mit einem zweiten Instruktionssatz lauffähig ist, wobei der zweite Instruktionssatz des Rechenkerns zweiten Typs von dem ersten Instruktionssatz des Rechenkerns ersten Typs verschieden ist. Weiterhin führt ein Rechenkern ersten Typs einen Emulator zur Emulation des zweiten Rechenkerns aus, wobei der Emulator den Steuergerätecode ausführt. Die Lösung erfolgt zusätzlich dadurch, dass der Emulator eine Simulationsumgebungsschnittstelle zum Austausch von Daten und/oder Ereignissen mit der Simulationsumgebung aufweist.

Mit der erfindungsgemäßen Testeinrichtung ist es möglich, den Steuergerätecode in seiner originären Form mit der Testeinrichtung auszuführen, es bedarf keiner Übersetzung des Steuergerätecodes aus einer Hochsprache in den ersten Instruktionssatz des ersten Rechenkerns, der Bestandteil der Testeinrichtung ist. Die Ausführbarkeit des Steuergerätecodes, der nur auf einem Rechenkern zweiten Typs mit einem zweiten Instruktionssatz lauffähig ist, wird durch den Einsatz eines Emulators zur Emulation des zweiten Rechenkerns möglich, wobei der Emulator selbst auf einem Rechenkern des ersten Typs ausgeführt wird. Der Emulator ist damit das Bindeglied zwischen dem Rechenkern zweiten Typs, also dem Rechenkern des zu testenden Steuergeräts, und dem Rechenkern ersten Typs der Testeinrichtung.

Von großer Bedeutung ist die Simulationsumgebungsschnittstelle des Emulators, über die mit der Simulationsumgebung Daten und/oder Ereignisse austauschbar sind, also beispielsweise Zustände von Pins der I/O-Schnittstelle des Steuergeräts - sowohl ausgehend von dem emulierten Steuergerät als Eingangsgröße der Simulationsumgebung, wie auch ausgehend von der Simulationsumgebung als Eingangsgröße des emulierten Steuergeräts - und beispielsweise Triggersignale auf Interrupt-Leitungen usw. Die Simulationsumgebungsschnittstelle ist von besonderer Bedeutung, weil sie die Synchronisierung und Synchronisierbarkeit der Ausführung der Emulation des Steuergeräts und des Steuergerätecodes auf dem Emulator zum einen und die Ausführung der Simulationsumgebung und damit der Echtzeitsimulation der Umgebung des virtuellen Steuergeräts zum anderen ermöglicht. Die Simulationsumgebungsschnittstelle ist damit auch Voraussetzung für die echtzeitmäßige Ausführung des Steuergerätecodes durch den Emulator auf einem Rechenkern ersten Typs.

Es ist durchaus möglich, dass die Testeinrichtung mehrere Rechenkerne ersten Typs aufweist, so dass die Simulationsumgebung z. B. auf einem Rechenkern ersten Typs ausgeführt wird und der Emulator auf einem anderen Rechenkern ersten Typs ausgeführt wird.

In einer bevorzugten Ausgestaltung der Erfindung ist vorgesehen, dass die Simulationsumgebung wenigstens einen Simulator und ein Prozessmodell umfasst, wobei der Simulator über die Simulationsumgebungsschnittstelle durch den Emulator aufrufbar ist und/oder umgekehrt, der Emulator über die Simulationsumgebungsschnittstelle durch den Simulator aufrufbar ist. Damit wird ermöglichst, dass der Emulator bzw. die Emulation des Steuergerätecodes auf Ereignisse reagieren kann, beispielsweise Ereignisse aus der Echtzeitsimulation der Umgebung des virtuellen Steuergeräts. Diese Verknüpfung zwischen Simulationsumgebung und dem Steuergerätecode kann beispielsweise anhand des physikalischen Kontextes des emulierten Steuergeräts oder mittels Schnittstellen-Routinen geschehen, wobei der physikalische Kontext die physikalischen Anschlüsse und Register des emulierten Steuergeräts beschreibt, wie z. B. Interrupt-Leitungen. Bei Verwendung von Interface-Routinen wird bei Eintritt eines Ereignisses eine vorherbestimmte Funktion innerhalb des Steuergerätecodes durch den Emulator ausgeführt. Die Bestimmung dieser Funktion kann mithilfe von Symboltabellen und einer Beschreibung, welche Interface-Routinen in dem Steuergerät vorhanden sind, automatisiert realisiert werden.

Wenn die Simulationsumgebung einen Simulator und ein Prozessmodel umfasst, dann ist ferner in einer bevorzugten Ausgestaltung vorgesehen, dass über die Simulationsumgebungsschnittstelle zwischen dem Emulator und dem Prozessmodell Daten und/oder Ereignisse austauschbar sind. Die erfindungsgemäße Testeinrichtung ist mit anderen Worten vorzugsweise so ausgestaltet, dass bei Aufruf des Emulators durch den Simulator mittels der Simulationsumgebungsschnittstelle der Emulator den Ausführungskontext des Steuergerätecodes erfasst, der Emulator den von dem Aufruf betroffenen Teil des Steuergerätecodes ausführt und der Emulator den Ausführungskontext des Steuergerätecodes aktualisiert. Der Ausführungskontext beschreibt dabei alle Randbedingungen, von denen die Ausführung des Steuergerätecodes auf dem Emulator abhängt, neben internen Zustandsgrößen auch jene Zustandsgrößen, die die Schnittstelle des emulierten Steuergeräts beschreiben und die gegebenenfalls auch von der Simulationsumgebung beeinflusst sind.

Die Testeinrichtung wird vorzugsweise so ausgestaltet sein, dass der Steuergerätecode vollständig ist, er insbesondere das Betriebssystem, Treiber und sämtliche Softwarekomponenten des Steuergeräts umfasst, so dass der zuvor genannte Ausführungskontext den vollständigen physikalischen Kontext des virtuellen Steuergeräts beschreibt. Unter dieser Voraussetzung erfasst der Test des virtuellen Steuergeräts praktisch alle Aspekte des dem virtuellen Steuergerät entsprechenden realen Steuergeräts. Alternativ können aber auch solche Anwendungsfälle von der erfindungsgemäßen Testeinrichtung erfasst werden, bei denen der Steuergerätecode unvollständig ist, insbesondere das Betriebssystem und Treiber des Steuergeräts nicht umfasst sind, so dass der Ausführungskontext nur Softwarekomponenten des virtuellen Steuergeräts umfasst.

In einer besonders bevorzugten Variante der erfindungsgemäßen Testeinrichtung ist vorgesehen, dass die Berechnung des Steuergerätecodes durch den Emulator datengetrieben über die Simulationsumgebungsschnittstelle zwischen dem Emulator und der Simulationsumgebung, insbesondere zwischen dem Emulator und dem Prozessmodel, erfolgt. Über diesen Mechanismus ist auch eine Synchronisation der Ausführung des Steuergerätecodes durch den Emulator mit der Berechnung der Simulationsumgebung bzw. des Prozessmodels der Simulationsumgebung möglich.

Bei einer dazu alternativen Ausgestaltung der Testeinrichtung ist vorgesehen, dass die Simulationsumgebung wenigstens einen Simulator und ein Prozessmodel umfasst, wobei der Simulator von dem Prozessmodel aufrufbar ist und/oder das Prozessmodel durch den Simulator aufrufbar ist. In diesem Fall ist die Testeinrichtung vorzugsweise so ausgestaltet, dass die Berechnung des Prozessmodels und die Ausführung des Steuergerätecodes durch den Emulator zentral über den Simulator gesteuert sind, so dass auf diese Weise die gewünschte synchrone Ausführung erzielt wird, insbesondere die zeitliche Koordination der Berechnung des Prozessmodels und die Ausführung des Steuergerätecodes.

Unabhängig davon, nach welcher der zuvor dargestellten Methoden eine Synchronisation zwischen der Echtzeitberechnung des Prozessmodels und der Ausführung des Steuergerätecodes durch den Emulator hergestellt wird, besteht natürlich ein Interesse daran, den Steuergerätecode zeitlich optimiert auf dem Emulator auszuführen, damit die in jedem Abtastintervall anfallenden Berechnungen jedenfalls innerhalb dieses Intervalls auch unterbrechungsfrei abgeschlossen werden können und nicht schon durch eine hier auftretende Limitierung gegen das Echtzeiterfordernis verstoßen wird. Zur Optimierung des Laufzeitverhaltens können alle bekannten Maßnahmen und Techniken verwendet werden. Ferner kann im Fall der Interpretation des Steuergerätecodes dafür gesorgt werden, dass Speicherreservierungen zur Laufzeit reduziert oder gänzlich vermieden werden. Im Falle der binären Translation des Steuergerätecodes könnte eine geeignete Maßnahme darin bestehen, dass alle atomaren Codeblöcke a priori identifiziert und vor der Laufzeit übersetzt werden. Alternativ kann der Blockcache so groß gewählt, dass nach einer Initialisierungsphase sämtliche für die Simulation benötigten Codeblöcke übersetzt worden sind und demzufolge keine Verdrängungen im Blockcache mehr stattfinden. Eine weitere Maßnahme kann darin bestehen, Kettenreferenzen im Steuergerätecode zu erkennen und aufzulösen.

Die eingangs hergeleitete Aufgabe kann auch verfahrensmäßig gelöst werden, wobei zur Durchführung des erfindungsgemäßen Verfahrens von einer Testeinrichtung zum Echtzeittest zumindest eines Teils eines virtuellen Steuergeräts mit einem Steuergerätecode ausgegangen wird, wobei die Testeinrichtung wenigstens einen Rechenkern ersten Typs mit einem ersten Instruktionssatz und wenigstens eine Simulationsumgebung zur Simulation der Umgebung des virtuellen Steuergeräts aufweist. Das Verfahren sieht vor, dass die Simulationsumgebung und der Steuergerätecode mit wenigstens einen Rechenkern ersten Typs berechnet wird. Ferner ist vorgesehen, dass der Steuergerätecode so bereitgestellt wird, dass er auf einem Rechenkern zweiten Typs mit einem zweiten Instruktionssatz ausgeführt werden kann, wobei es sich bei dem Rechenkern zweiten Typs üblicherweise um den Rechenkern des zu testenden Seriensteuergeräts handelt. Insoweit ist der zweite Instruktionssatz des Rechenkerns zweiten Typs von dem ersten Instruktionssatz des Rechenkerns ersten Typs verschieden. Verfahrensgemäß ist dann vorgesehen, dass ein Emulator zur Emulation des zweiten Rechenkerns auf einem Rechenkern ersten Typs der Testeinrichtung ausgeführt wird und der Emulator seinerseits den Steuergerätecode ausführt. Ferner ist erfindungsgemäß vorgesehen, dass Daten und/oder Ereignisse zwischen dem Emulator und der Simulationsumgebung ausgetauscht werden, wobei der Signalfluss in beide Richtungen erfolgen kann, Daten und/oder Ereignisse können also von dem Emulator in Richtung auf die Simulationsumgebung mitgeteilt werden wie auch von der Simulationsumgebung in Richtung zum Emulator. Durch die erfindungsgemäße Vorgehensweise wird ganz allgemein die Möglichkeit geschaffen, die in Echtzeit durchgeführte Simulation der Umgebung des virtuellen Steuergeräts mit der Emulation des Steuergerätecodes zu synchronisieren, so dass der Steuergerätecode durch den Emulator auch in Echtzeit ausgeführt wird.

Im Einzelnen gibt es eine Vielzahl von Möglichkeiten, die erfindungsgemäße Testeinrichtung auszugestalten und weiterzubilden. Dazu wird verwiesen einerseits auf die dem Patentanspruch 1 nachgeordneten Patentansprüche, andererseits auf die folgende Beschreibung von Ausführungsbeispielen in Verbindung mit der Zeichnung. In der Zeichnung zeigen
- Fig. 1a: eine aus dem Stand der Technik bekannte Testeinrichtung mit zu testenden realen Steuergeräten,
- Fig. 1b: eine aus dem Stand der Technik bekannte Testeinrichtung mit zu testenden virtuellen und realen Steuergeräten,
- Fig. 2a: ein erstes Ausführungsbeispiel einer erfindungsgemäßen Testeinrichtung mit einem virtuellen Steuergerät,
- Fig. 2b: das Ausführungsbeispiel gemäß Fig. 1a mit einer Kombination aus virtuellen und realen Steuergeräten,
- Fig. 3: ein weiteres Ausführungsbeispiel einer erfindungsgemäßen Testeinrichtung,
- Fig. 4: ein Ausführungsbeispiel einer erfindungsgemäßen Testeinrichtung mit datengetriebenem Emulator und
- Fig. 5: ein weiteres Ausführungsbeispiel einer erfindungsgemäßen Testeinrichtung mit einem von einem Simulator gesteuerten Emulator.

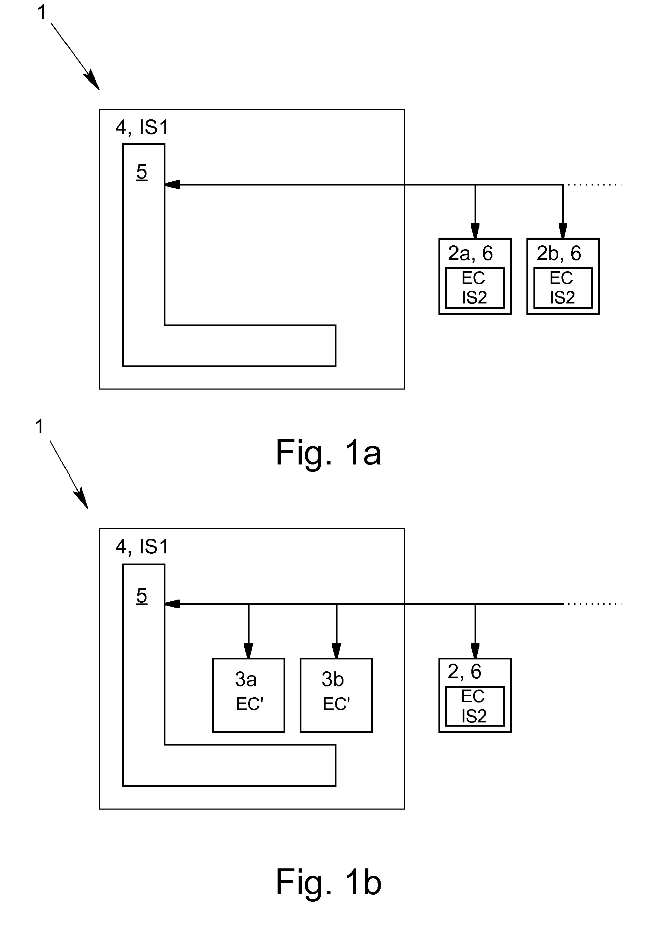

Fig. 1a zeigt schematisch eine aus dem Stand der Technik bekannte Testeinrichtung 1 zum Echtzeittest von realen Steuergeräten 2a, 2b. Demgegenüber ist in Fig. 1b eine aus dem Stand der Technik bekannte Testeinrichtung 1 dargestellt, die neben realen zu testenden Steuergeräten 2 auch zwei zu testende virtuelle Steuergeräte 3a, 3b aufweist. Die Testeinrichtungen 1 weisen einen Rechenkern 4 ersten Typs auf, der durch einen ersten Instruktionssatz IS1 ausgezeichnet ist. Die in den Fig. 1a und 1b dargestellten Testeinrichtungen 1 weisen ferner eine Simulationsumgebung 5 zur Echtzeitsimulation der Umgebung des zu testenden Steuergeräts auf. Die realen, also physikalisch vorhandenen Steuergeräte 2 weisen einen Rechenkern 6 zweiten Typs auf, wobei dieser Rechenkern 6 zweiten Typs durch einen zweiten Instruktionssatz IS2 gekennzeichnet ist. In den dargestellten Beispielen unterscheidet sich der zweite Instruktionssatz IS2 des Rechenkerns 6 zweiten Typs der Steuergeräte von dem ersten Instruktionssatz IS1 des Rechenkerns 4 ersten Typs der Testeinrichtung 1.

In den Fig. 1a, 1b ist die Testeinrichtung 1 PC-basiert, der erste Instruktionssatz IS1 ist im dargestellten Beispiel kompatibel mit der Intel 32-Bit-x86-Architektur (IA-32). Bei den Rechenkernen 6 zweiten Typs handelt es sich um Mikrocontroller mit Rechenkernen des Typs C166, so dass der diesbezügliche zweite Instruktionssatz IS2 jedenfalls verschieden ist von dem ersten Instruktionssatz IS1 des Rechenkerns 4 ersten Typs der Testeinrichtung 1. Die realen Steuergeräte 2 sind über ihre physikalische Schnittstelle mit einer korrespondierenden physikalischen I/O-Schnittstelle der Testeinrichtung 1 verbunden.

Im Falle des Echtzeittests von realen Steuergeräten 2 gemäß Fig. 1a kann der Steuergerätecode EC ohne weiteres in seiner originären Form, nämlich zugeschnitten auf den zweiten Instruktionssatz IS2 des Rechenkerns 6 zweiten Typs, ausgeführt werden. Der Test des Steuergerätecodes EC des realen Steuergeräts 2 setzt aber voraus, dass das reale Steuergerät 2 tatsächlich physikalisch vorhanden ist, was mit den bereits beschriebenen Nachteilen verbunden ist.

Die Testeinrichtung 1 gemäß Fig. 1b arbeitet - auch - mit virtuellen Steuergeräten 3a, 3b. Diese Steuergeräte liegen physikalisch nicht vor, sie werden vielmehr dadurch realisiert, dass der Steuergerätecode EC in den ersten Instruktionssatz IS1 des Rechenkerns 4 ersten Typs der Testeinrichtung 1 übersetzt wird, so dass der übersetzte Steuergerätecode EC', auf der Testeinrichtung 1 lauffähig ist. Dies ermöglicht zwar den frühzeitigen Test von Steuergerätecode, ohne dass ein reales Steuergerät vorhanden sein muss, nachteilig ist jedoch, dass nicht der originäre Steuergerätecode EC getestet wird, sondern die übersetzte Variante EC'. Ferner muss der Steuergerätecode EC in einer Hochsprache vorliegen, so dass die Übertragung auf den ersten Instruktionssatz IS1 des Rechenkerns 4 ersten Typs überhaupt möglich ist.

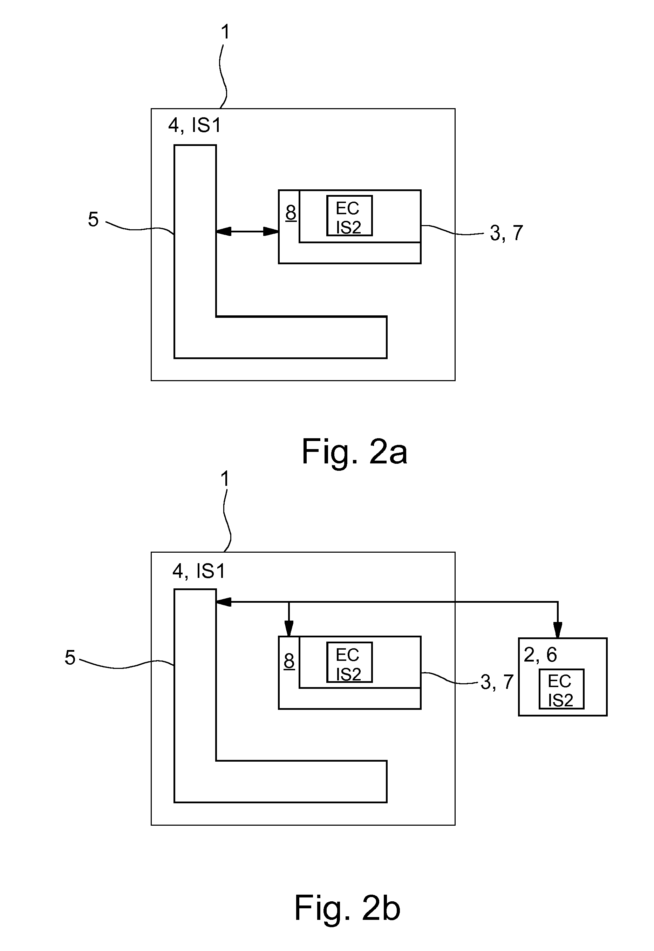

In den Fig. 2a, 2b ist nun eine erfindungsgemäße Testeinrichtung 1 dargestellt. Auch hier weist die Testeinrichtung 1 einen Rechenkern 4 ersten Typs mit einem ersten Instruktionssatz IS1 auf, wobei auch hier eine Simulationsumgebung 5 zur Echtzeitsimulation der Umgebung des virtuellen Steuergeräts 3 dient. Auch hier wird der Steuergerätecode EC des virtuellen Steuergeräts 3 letztendlich mit Hilfe des Rechenkerns 4 ersten Typs berechnet, es besteht jedoch gegenüber den aus dem Stand der Technik bekannten Testeinrichtungen - beispielsweise gemäß den Fig. 1a und 1b - ein weitreichender Unterschied. Der Steuergerätecode EC des virtuellen Steuergeräts 3 ist lauffähig auf einem Rechenkern zweiten Typs mit einem zweiten Instruktionssatz IS2, wobei sich der zweite Instruktionssatz IS2 von dem ersten Instruktionssatz IS1 des Rechenkerns 4 ersten Typs der Testeinrichtung 1 unterscheidet. Gleichwohl kann der eigentlich für den Rechenkern zweiten Typs gedachte Steuergerätecode EC mit der Testeinrichtung 1 ausgeführt werden, da der Rechenkern 4 ersten Typs der Testeinrichtung 1 einen Emulator 7 ausführt, wobei dieser Emulator 7 den Rechenkern zweiten Typs emuliert und der emulierte Rechenkern zweiten Typs den Steuergerätecode ausführt. Durch diese Maßnahme ist eine Übertragung des Steuergerätecodes EC, der auf einem Rechenkern zweiten Typs mit einem zweiten Instruktionssatz IS2 lauffähig ist, auf den ersten Instruktionssatz IS1 nicht erforderlich, es kann grundsätzlich der originäre Steuergerätecode EC, der in Regel für eine andere Zielhardware als die der Testeinrichtung 1 erstellt ist, ausgeführt werden. Es besteht nicht mehr das Erfordernis, dass der Steuergerätecode EC in einer Hochsprache vorliegen muss, um eine Umwandlung auf den ersten Instruktionssatz IS1 der Testeinrichtung vornehmen zu können.

Wichtig ist, dass der Emulator 7 eine Simulationsumgebungsschnittstelle 8 aufweist, über die der Emulator 7 Daten und/oder Ereignisse mit der Simulationsumgebung 5 austauschen kann. Die Simulationsumgebungsschnittstelle 8 ist mit dieser Funktionalität essentiell zur Verwendung des Emulators 7 im Rahmen einer Echtzeitsimulation, da die Simulationsumgebungsschnittstelle 8 eine Synchronisation der Echtzeitsimulation der Umgebung des virtuellen Steuergeräts 3 und der Emulation des Rechenkerns zweiten Typs durch den Emulator 7 ermöglicht.

In Fig. 2b ist dargestellt, dass die erfindungsgemäße Testeinrichtung 1 nicht darauf beschränkt ist, ausschließlich ein virtuelles Steuergerät 3 oder mehrere virtuelle Steuergeräte 3 zu testen, sondern dass es vielmehr auch möglich ist, die Testeinrichtung 1 auch mit externen realen Steuergeräten 2 zu betreiben. Das in Fig. 2b dargestellte Ausführungsbeispiel des gleichzeitigen Tests von virtuellen Steuergeräten 3 mit realen Steuergeräten 2 bzw. eines gemischten Steuergeräte-Verbunds dürfte einen häufigen Anwendungsfall der erläuterten Testeinrichtung 1 darstellen.

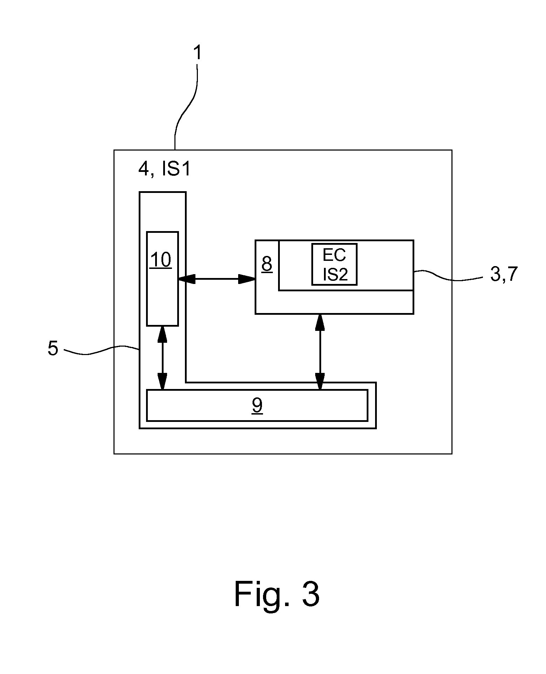

In Fig. 3 ist die Testeinrichtung 1 dargestellt, wobei die Simulationsumgebung 5 einen Simulator 9 und ein Prozessmodell 10 umfasst. Der Simulator 9 ist über die Simulationsumgebungsschnittstelle 8 durch den Emulator 7 aufrufbar, und umgekehrt ist der Emulator 7 über die Simulationsumgebungsstelle 8 durch den Simulator 9 aufrufbar. Der Simulator 9 stellt insgesamt eine echtzeitfähige Plattform dar, um das Prozessmodell 10 unter Berücksichtigung von Echtzeitbedingungen auszuführen. Neben einer Echtzeitumgebung verfügt der Simulator auch über geeignete numerische Verfahren, um das Prozessmodell 10 berechnen zu können. Der Simulator 9 koordiniert damit zeitlich die Ausführung verschiedener Tasks des Prozessmodells 10 und stellt Mittel zur Verfügung, um auch nichtperiodische Ereignisse im Rahmen der Simulation berücksichtigen zu können.

In Fig. 3 ist weiterhin zu erkennen, dass über die Simulationsumgebungsschnittstelle 8 zwischen dem Emulator 7 und dem Prozessmodell 10 Daten ausgetauscht werden können. Das Prozessmodell 10 hat dazu Kenntnis von den Schnittstellen des emulierten virtuellen Steuergeräts 3, so dass eine datenmäßige Verzahnung zwischen Prozessmodell 10 und emuliertem virtuellen Steuergerät 3 gegeben ist.

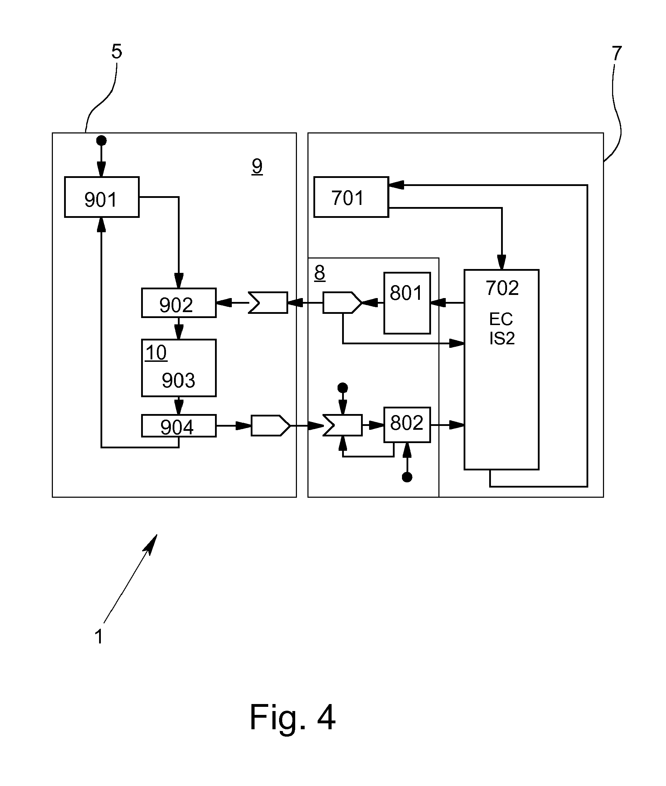

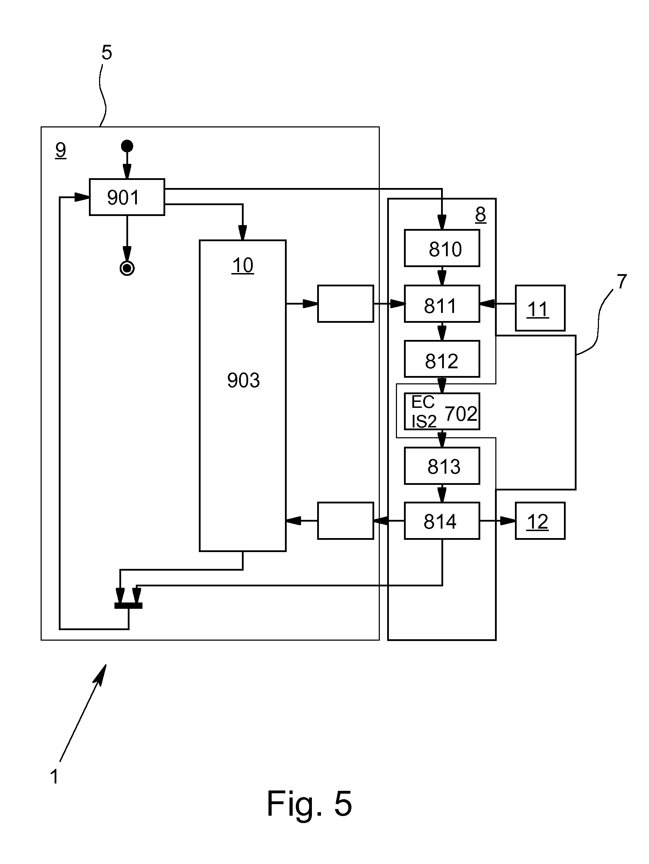

In den Fig. 4 und 5 sind erfindungsgemäße Testeinrichtungen 1 dargestellt, wobei anhand der Blockschaltbilder nicht nur die Strukturen der Testeinrichtungen 1 dargestellt werden sollen, sondern auch Funktionsabläufe innerhalb der Testeinrichtungen 1 erkennbar werden sollen. In beiden Darstellungen stehen sich jeweils gegenüber die Simulationsumgebung 5 und der Emulator 7 mit der Simulationsumgebungsschnittstelle 8, über die die Simulationsumgebung 5 mit dem Emulator 7 wechselwirkt. In der Simulationsumgebung 5 ist jeweils auch der Simulator 9 mit dem Prozessmodell 10 dargestellt.

In Fig. 4 ist zu erkennen, dass über die Simulationsschnittumgebungsschnittstelle 8 zwischen dem Emulator 7 und dem Prozessmodell 10 Daten austauschbar sind. Das Ausführungsbeispiel gemäß Fig. 4 zeichnet sich dadurch aus, dass die Ausführung des Steuergerätecodes EC durch den Emulator 7 datengetrieben über die Simulationsumgebungsschnittstelle 8 zwischen dem Emulator 7 und dem Prozessmodell 10 erfolgt. Über die Simulationsumgebungsschnittstelle 8 wird demnach erkannt, ob sich interessierende Zustandsgrößen des Prozessmodells 10 und damit beispielsweise Signale auf bestimmten Kanälen der Schnittstelle geändert haben, woraufhin entsprechende Aktionen in dem Emulator 7 ausgelöst werden.

Ausgehend vom Ruhezustand 901 des Simulators 9 wird ein nächster Berechnungsschritt für das Prozessmodell 10 getriggert. Dazu werden zunächst in einer Input-Routine 902 vom Emulator 7 berechnete relevante Steuergerätedaten gelesen.

Die Berechnungen auf dem Emulator 7 gehen dort ebenfalls von einem Ruhezustand 701 aus, wobei der Emulator 7 im Schritt 702 ausgeführt wird. Der Zustand 702 kann durch verschiedene Arten der Triggerung erreicht werden. Der Zustand 702 kann so beispielsweise durch einen Timerinterrupt - ausgehend von Ruhezustand 701- oder durch ein Datenereignis erreicht werden. Im Falle eines Datenereignisses wird erst der Zustand 802 betreten und im Falle eines damit verknüpften Interrupts wird dann der Zustand 702 erreicht. Dies ist z. B. der Fall, wenn ein Pin-Change-Interrupt mit einem I/O-Pin verknüpft ist. Ist kein Interrupt mit dem I/O-Pin verknüpft, wird der Zustand 802 wieder verlassen und es folgt keine weitere Aktion in 702. Zustand 802 stellt dann sicher, dass die Daten für den Emulator entsprechend codiert vorliegen, also im Ausführungskontext des Emulators.

Mit dem Emulator wird auch der Steuergerätecode EC ausgeführt, der im zweiten Instruktionssatz IS2 vorliegt. Der Simulator 9 und der Emulator 7 laufen praktisch parallel. Die Emulation wird nur - wie zuvor ausgeführt - im Falle eines mit einem Ereignis verknüpften Interrupts unterbrochen, andernfalls werden lediglich wechselseitig auszutauschende Daten über die Simulationsumgebungsschnittstelle 8 verfügbar gemacht und von Emulator 7 bzw. Simulator 9 gelesen.

Nach Abschluss eines Berechnungsschrittes 903 des Prozessmodells 10 werden die aktuellen Zustandsgrößen des Prozessmodells 10 in der Ausgabefunktion 904 dem Emulator zur Verfügung gestellt. Dies geschieht in der Simulationsumgebungsschnittstelle 8 im Block 802 entweder einfach durch Abspeicherung des physikalischen Kontextes des Emulators 7 oder durch Aufruf entsprechender Schnittstellenfunktionen im Steuergerätecode EC. Unter der "Abspeicherung des physikalischen Kontexts" ist dabei zu verstehen, dass beispielsweise veränderte I/O-Signale durch geeignete Speicherung der veränderten I/O-Signale im Kontext des Emulators dem Emulator verfügbar gemacht werden. Der Aufruf einer Schnittstellenfunktion innerhalb des Steuergerätecodes EC im Schritt 702 wird hingegen nur dann vorgenommen, wenn die Nutzung einer solchen Schnittstellenfunktion entsprechend konfiguriert ist und ein Interrupt innerhalb des Steuergerätecodes EC ausgelöst würde. Ist kein Interrupt verknüpft, wird lediglich - wie zuvor erläutert - die Information als solche zur Verfügung gestellt. Letzteres bedeutet in diesem Zusammenhang, dass das Signal physikalisch anliegt und als solches durch geeignete Speicherung zur Nutzung verfügbar gemacht worden ist und durch einen entsprechenden einfachen Lesevorgang genutzt werden kann; es werden aber keine Schritte im Block 702 ausgelöst. Entsprechendes gilt für die Berechnungen 903 im Prozessmodell 10.

In dem Ausführungsbeispiel gemäß Fig. 5 wird die Synchronisation zwischen der Simulationsumgebung 5 und dem Emulator 7 dadurch erzielt, dass die Berechnung des Prozessmodells 10 und die Ausführung des Steuergerätecodes EC durch den Emulator 7 zentral über den Simulator 9 gesteuert sind, was vorliegend vor allem die zeitliche Koordination der Berechnung 903 des Prozessmodells 10 und der Ausführung 702 des Steuergerätecodes EC betrifft. In Fig. 5 ist zu erkennen, wie aus dem Ruhezustand 901 des Simulators sowohl das Prozessmodell 10 wie auch die Ausführung des Emulators 7 über die Simulationsumgebungsschnittstelle 8 getriggert wird, wodurch die zeitliche Synchronisation gewährleistet ist. Dies setzt natürlich voraus, dass das Prozessmodell 10 durch den Simulator 9 aufrufbar ist. Auf der Seite des Emulators 7 wird im Schritt 810 zunächst die Funktionalität des Steuergeräts bestimmt, die bearbeitet werden muss. Nachfolgend werden im Schritt 811 alle aktuellen Eingangsgrößen eingelesen, sowohl die Eingangsgrößen, die von dem Prozessmodell 10 zur Verfügung gestellt werden, wie auch andere Eingangsgrößen aus möglichen externen Quellen 11. Im Schritt 812 wird der Ausführungskontext aus den physikalischen Daten erstellt, so dass die Informationen durch eine einfache Leseoperation für den Emulator 7 verfügbar sind. Für den Fall, dass mit Schnittstellenroutinen gearbeitet wird, erfolgt direkt im Schritt 702 die Bearbeitung einer entsprechenden Funktion des Steuergerätecodes EC durch den Emulator 7. Nach der erfolgten Berechnung wird im Schritt 813 der Ausführungskontext mit den aktualisierten Daten wieder abgespeichert und durch Ausführung der Ausgabefunktion im Schritt 814 werden entsprechende Ausgänge beschrieben, einerseits Ausgänge betreffend das Prozessmodell 10, andererseits Ausgänge, die externe Datensenken 12 betreffen. In dieser Art und Weise werden - in Echtzeit - die Berechnungsschritte betreffend das Prozessmodell 10 und betreffend den Steuergerätecode EC auf dem Emulator 7 synchron zueinander berechnet.

In den Ausführungsbeispielen gemäß den Fig. 4 und 5 interpretiert der Emulator 7 jeden aufgerufenen Befehl des Steuergerätecodes EC im zweiten Instruktionssatz IS2 zur Laufzeit und führt diesen aufgerufenen Befehl dann funktional identisch mit dem entsprechenden Befehl des ersten Instruktionssatzes IS1 auf einem Rechenkern des ersten Typs der Testeinrichtung 1 aus.

## Patentansprüche

1. Testeinrichtung (1) zum Echtzeittest zumindest eines Teils eines virtuellen Steuergeräts (3) mit einem Steuergerätecode (EC), wobei die Testeinrichtung (1) wenigstens einen Rechenkern (4) ersten Typs mit einem ersten Instruktionssatz (IS1) und wenigstens eine Simulationsumgebung (5) zur Echtzeitsimulation der Umgebung des virtuellen Steuergeräts (3) aufweist, und wobei die Simulationsumgebung (5) und der Steuergerätecode (EC) mit wenigstens einem Rechenkern (4) ersten Typs berechnet wird,
**dadurch gekennzeichnet,**
**dass** der Steuergerätecode (EC) auf einem Rechenkern (6) zweiten Typs mit einem zweiten Instruktionssatz (IS2) lauffähig ist, wobei der zweite Instruktionssatz (IS2) des Rechenkerns (6) zweiten Typs von dem ersten Instruktionssatz (IS1) des Rechenkerns (4) ersten Typs verschieden ist,
**dass** ein Rechenkern (4) ersten Typs einen Emulator (7) zur Emulation des Rechenkerns (6) zweiten Typs ausführt und der Emulator (7) den Steuergerätecode (EC) ausführt und
**dass** der Emulator (7) eine Simulationsumgebungsschnittstelle (8) zum Austausch von Daten und/oder Ereignissen mit der Simulationsumgebung (5) aufweist.

2. Testeinrichtung (1) nach Anspruch 1, **dadurch gekennzeichnet, dass** die Simulationsumgebung (5) wenigstens einen Simulator (9) und ein Prozessmodell (10) umfasst, wobei der Simulator (9) über die Simulationsumgebungsschnittstelle (8) durch den Emulator (7) aufrufbar ist und/oder der Emulator (7) über die Simulationsumgebungsschnittstelle (8) durch den Simulator (9) aufrufbar ist.

3. Testeinrichtung (1) nach Anspruch 2, **dadurch gekennzeichnet, dass** über die Simulationsumgebungsschnittstelle (8) zwischen dem Emulator (7) und dem Prozessmodell (10) Daten austauschbar sind.

4. Testeinrichtung (1) nach Anspruch 2 oder 3, **dadurch gekennzeichnet, dass** bei Aufruf des Emulators (7) durch den Simulator (9) mittels der Simulationsumgebungsschnittstelle (8) der Emulator (7) den Ausführungskontext des Steuergerätecodes (EC) erfasst, der Emulator (7) den von dem Aufruf betroffenen Teil des Steuergerätecodes (EC) ausführt und der Emulator (7) den Ausführungskontext des Steuergerätecodes (EC) aktualisiert.

5. Testeinrichtung (1) nach Anspruch 4, **dadurch gekennzeichnet, dass** der Steuergerätecode (EC) vollständig ist, insbesondere das Betriebssystem, Treiber und sämtliche Softwarekomponenten des Steuergeräts umfasst, so dass der Ausführungskontext den vollständigen physikalischen Kontext des virtuellen Steuergerätes (3) umfasst.

6. Testeinrichtung (1) nach Anspruch 4, **dadurch gekennzeichnet, dass** der Steuergerätecode (EC) unvollständig ist, insbesondere das Betriebssystem und Treiber nicht umfasst, so dass der Ausführungskontext nur Softwarekomponenten des virtuellen Steuergeräts (3) umfasst.

7. Testeinrichtung (1) nach Anspruch 3 oder nach einem der Ansprüche 4 bis 6 insoweit rückbezogen auf Anspruch 3, **dadurch gekennzeichnet, dass** die Berechnung des Steuergerätecodes (EC) durch den Emulator (7) datengetrieben über die Simulationsumgebungsschnittstelle (8) zwischen dem Emulator (7) und dem Prozessmodell (10) erfolgt.

8. Testeinrichtung (1) nach einem der Ansprüche 2 und 3 bis 7, insoweit rückbezogen auf Anspruch 2, **dadurch gekennzeichnet, dass** die Berechnung des Prozessmodells (10) und die Ausführung des Steuergerätecodes (EC) durch den Emulator (7) zentral über den Simulator (9) gesteuert sind, insbesondere die zeitliche Koordination der Berechnungen (903) des Prozessmodells (10) und die Ausführung (702) des Steuergerätecodes (EC).

9. Testeinrichtung (1) nach einem der Ansprüche 1 bis 8, **dadurch gekennzeichnet, dass** der Emulator (7) jeden aufgerufenen Befehl des Steuergerätecodes (EC) im zweiten Instruktionssatz (IS2) zur Laufzeit interpretiert und funktional identisch mit Befehlen des ersten Instruktionssatzes (IS1) und auf einem Rechenkern (4) des ersten Typs ausführt.

10. Testeinrichtung (1) nach einem der Ansprüche 1 bis 9, **dadurch gekennzeichnet, dass** der Emulator (7) den Steuergerätecode (EC) vollständig oder in teilen unmittelbar vor der Ausführung in den ersten Instruktionssatz (IS1) übersetzt, insbesondere wobei vor der Übersetzung so viel Speicher für den in den ersten Instruktionssatz (IS1) übersetzten Steuergerätecode (EC') allokiert wird wie auf dem virtuellen Steuergerät (3) tatsächlich zur Verfügung steht.
